# EUROPEAN PATENT APPLICATION

(11) **EP 3 614 326 A1**
(43) Date of publication of application: **26.02.2020**
(21) Application number: 18189670.5
(22) Date of filing: 20.08.2018
(51) Int. Cl.: G06Q 30/02, G06Q 50/16

(54) **SYSTEM AND METHOD FOR MAPPING A VIRTUAL BUILDING MODEL**

(71) Applicant: Siemens Schweiz AG, 8047 Zürich (CH)
(72) Inventor: Zechlin, Oliver, 6300 Zug (CH); Frey, Christian, 6314 Unterägeri (CH)
(74) Representative: Maier, Daniel Oliver

(57) **Abstract**

A system and method for mapping a virtual building model (10) especially for a real estate, comprising: the system is configured to use blockchain-based transactions for data acquisition and mapping of the model (110); processing devices (130, 140, 150, 160, 170, 180, 190) configured to process a data transaction message, wherein the data transaction message includes at least an identifier associated with a blockchain network and a data transaction amount; and a control device (120) configured to control the data transaction message and to store the data transaction amount.

## Description

The present invention generally relates to a system for mapping a virtual building model especially for a real estate.

The disclosure and transparency of real estate conditions is an essential component for every real estate management and plays for owners, lawyers, tenants, brokers, consultants, inspectors and other advisers a more and more important role. Among other things grant of credit directives and grant of credit orders as well as demands of prospective customers create a considerable inquiry for the entire disclosure of any conditions which take an influence on the value of a real estate. The real time data which provide information about the topical state of the building (Smart Building recorder) also belong beside historical data of the building technology to it.

Besides the legal demands there are several reasons why an entire transparency and real estate disclosure is an advantage. Different stakeholder, like buyers, investors or tenants preserve better knowledge about the real estate and its use, and brokers and consultants can better estimate additional costs and liability risks. Further, credit grantors receive a better understanding of their securities. However, it is not only about the price of the respective real estate values, but rather about information regarding the use of the real estate, the obstructed building-technical systems and their servicing intervals and state, special basic conditions, official requirements and known defects, as well as the present use intensity.

Furthermore, other market participants want to introduce their business solutions based on building data in the marketplace in order to profit economically from it. Especially, companies from the computer science field offer data analysis (Big Data, artificial intelligence) and give by using suitable algorithms predictions or action recommendations (e.g., predictive servicing) for potential customers. If the data of a real estate (building) are available, these companies are capable to generate a suitable customer offer for a real estate.

Real estate value and with a real estate linked values and risks, as well as data from the life cycle, are administered in different systems by the most different parties. Further, lists from table calculation programmes, or even handwritten notes often are beside dedicated computer-implemented software solutions in use and are stored frequently decentralised and without a possibility of the examination ad hoc. Hence, a quick overview of certain real estate values of operating and consumption costs is only hardly possible. This non-transparency complicates, e.g., investment decisions, because the knowledge about available values and costs is absent. There does not exist the one and universal transparency report for a real estate - and already not at all broken down on part real Therefore, consultants and experts who provide certificate and reports with high costs are often used to the inquiry of the transparency.

In view of the foregoing it is thus an object of the present invention to provide techniques that provide a better data disclosure and transparency for real estate management requirements.

According to a first aspect, the invention provides a system for mapping a virtual building model especially for a real estate, comprising that the system is configured to use blockchain-based transactions for data acquisition and mapping of the model, processing devices (configured to process a data transaction message, wherein the data transaction message includes at least an identifier associated with a blockchain network and a data transaction amount, and a control device configured to control the data transaction message and to store the data transaction amount.

Accordingly, the use of virtual building models in combination with blockchain may provide for all stakeholders involved in the management and use of a real estate the benefits of the decentralized blockchain while still maintaining security of their data information.

In some advantageous embodiments, the data transaction message is formatted based on one or more standards and includes a plurality of data elements, including at least a first data element configured to store the data transaction amount.

Preferably, in some advantageous embodiments, the processing devices are internet-of-things sensors and/or smart phones and/or servers and/or computing devices.

In some advantageous embodiments, an encrypted key can be used for the transaction message and/or the transaction amount.

In further advantageous embodiments, the transaction message may contain data of the building such as the construction plan, the equipment of the building, the history of the building, the users of the building and the infrastructure.

In some advantageous embodiments, authorized stakeholders have access to the virtual building model.

In further advantageous embodiments, the blockchain of the virtual building model comprises smart contracts for authorized stakeholder.

According to a second aspect, the invention provides a method for mapping a virtual building model especially for a real estate, comprising using blockchain-based transactions for data acquisition and mapping of the model, processing by processing devices a data transaction message, wherein the data transaction message includes at least an identifier associated with a blockchain network and a data transaction amount, and controlling the data transaction message and storing the data transaction amount by a control device.

In other advantageous embodiments, the data transaction message is formatted based on one or more standards and includes a plurality of data elements, including at least a first data element configured to store the data transaction amount.

Preferably, an encrypted key can be used for the transaction message and/or the transaction amount.

In other advantageous embodiments, the transaction message may contain data of the building such as the construction plan, the equipment of the building, the history of the building, the users of the building and the infrastructure.

In further advantageous embodiments, authorized stakeholders have access to the virtual building model.

In other advantageous embodiments, the blockchain of the virtual building model comprises smart contracts for authorized stakeholder.

According to a third aspect, the invention provides a cloud computing platform configured for use in the system according to the first aspect of the invention.

According to a fourth aspect, the invention provides a computer program product comprising executable program code configured to, when executed, perform the method according to the second aspect of the invention.

Additional features, aspects and advantages of the invention or of its embodiments will become apparent on reading the detailed description in conjunction with the following figures:
- Fig. 1: provides a general overview of a system for mapping a virtual building model according to an embodiment of the first aspect of the invention;
- Fig. 2: schematically illustrates a computer program product according to an embodiment of the fourth aspect of the invention.

In the following description, for purposes of explanation and not limitation, specific details are set forth in order to provide a thorough understanding of the present invention. It will be apparent to one skilled in the art that the present invention may be practiced in other implementations that depart from these specific details.

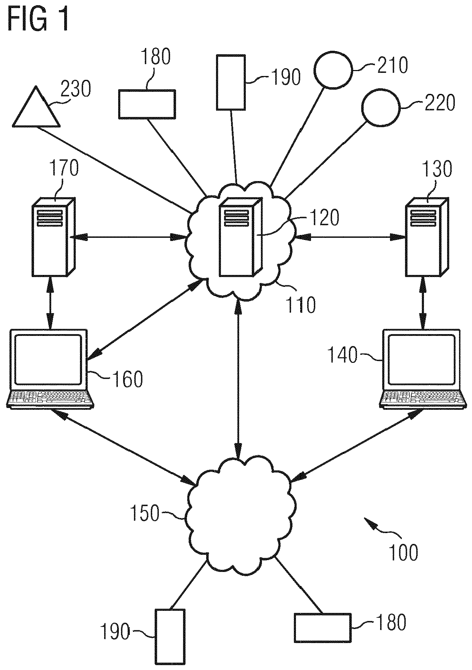

- Fig. 1: provides a general overview of a system 100 for mapping a virtual building model 110 according to an embodiment of the first aspect of the invention;

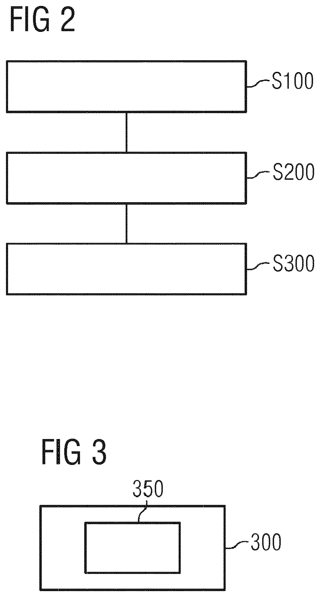

- Fig. 2: provides a schematic flow diagram illustrating an embodiment of a method according to the second aspect of the invention;
- Fig. 3: schematically illustrates a computer program product 300 comprising executable program code 350 configured to, when executed, perform the method according to the second aspect of the present invention, in particular as has been described with respect to Fig. 1.

A virtual digital mapping of the real estate represents the real estate values with corresponding operating costs and consumption costs, time period of utilisation and intensity of utilisation, obstructed building-technical systems with their repair reports, servicing reports and test reports, as well as basic conditions and categorised risks which have influence on the use and the value of a real estate.

This virtual digital mapping - also called "building information modelling" (BIM) - describes a method of optimised planning, implementation and management of buildings and other buildings with the help of software. Besides, all relevant building data are modelled digitally, combined and stored. The building is visualised as a virtual model also geometrically (computer model). Building information modelling finds applications in the civil engineering as well as in the building design and the execution of construction (architecture, engineering, house technology, civil engineering, town planning, railway construction, road construction, hydraulic engineering, geo-technology) as well as in the facility management.

Advantages arise in planning, execution and implementation of a building regarding reduction of incorrect planning, reduction of losses of information, reduction of redundant works, untimely recognising of collisions, better cost control by model-based derivations. Furthermore, advantages arise for developers and operators in respect of visualisation and simulation of variations and scenarios to the decision-making, higher and earlier cost safety and appointment safety, clearer and transparent planning, entire documentation, takeover of the data in the life cycle management and optimisation of the facility management.

The planning achievement is shifted timewise forwards. In the ideal case a virtual building, up to the last screw, already originates in the planning. By the realisation less costs originate from it. Perhaps, the approval process can also be thereby accelerated.

Essential for the quality of the model BIM is its degree of details. A good BIM program should allow that one starts summarily to go then to the detail - from the approximate to the fine. Furthermore, the modelling up to the last screw can be a reason to accelerate the approval process of the building site.

The virtual digital building model 110 is stored centrally or decentralised on one or several servers 120 (e.g., cloud service), and uses a data memory which from different sources 130, 140, 150, 160, 170 can be fed. These data are not only statistical values, as for example the size and inventory of a room, but also dynamic values, like the corresponding energy consumption, and with it linked costs. By evaluating of admission control or presence indication it is possible to estimate the use or the popularity of a room or building and to determine other statistical analyses. Internet-of-Things sensors (IoT) 180 can be used to measure further physical or chemical values like the temperature, the air pressure, chemical substances etc. of a room. By using data analysis algorithm evaluations in different categories and relations can be provided. Especially, in systems based on cloud computing technology, a large amount of sensors/devices 180 can be connected to a cloud computing system 150 via the Internet. The sensors/devices 180 can comprise, or consist of, equipment, sensors, actuators, robots, and/or machinery in a real estate or industrial set-up(s). Furthermore, it is possible to provide a secure transaction between smartphones 190 and other computing devices and the server 110 and/or cloud computing system 150 for data acquisition.

The cloud computing system 150 and/or the server 120 may enable remote configuring, monitoring, controlling, and maintaining connected devices 180 (also commonly known as 'assets'). Also, the cloud computing system 150 and/or the server 120 may facilitate storing large amounts of data periodically gathered from the devices, analyzing the large amounts of data, and providing insights (e.g., key performance indicators, outliners) and alerts to operators, field engineers or owners of the devices 180 via a graphical user interface (e.g., of web applications). The insights and alerts may enable controlling and maintaining the devices 180, leading to efficient and fail-safe operation of the devices 180. The cloud computing system 150 and/or the server 120 may also enable modifying parameters associated with the devices 180 and issues control commands via the graphical user interface based on the insights and alerts.

For special buildings like office or shopping building it would be possible to invoice dynamically to avoid rush hours (security aspects as too many people are in a building) or to ensure the steady use of the infrastructure. Therefore, different prices of the use of a special hour/day/week/month can be established. For example, the employees of a company are urged to come and go in "microlayers". This would have even the implied advantage of the traffic control beyond the building management, and therefore also again an influence on emission values.

Data of utilisation and/or consumption data can be transmitted to the account to the respective contracting partners. Furthermore, the data can be analysed concerning the optimisation potential and actions can be optionally initiated. It is also thinkable to transfer the data to third parties which can give further recommendations or offers (e.g., energy provider, assurance).

An exemplary procedure for providing a virtual mapping (representation) encloses determining a variety of qualities and restrictions corresponding to the physical position of real estate values relatively to each other. The virtual real estate representation is valued according to the determined criteria and can be displayed on a screen of a computing device, e.g., with a defined colour code. Optionally a benchmark with similar buildings and/or scenarios of utilisation and/ or with surroundings real estate can be carried out. Furthermore, an assessment seal of quality can be issued optionally, or the data set can be transmitted to a certification authority (which estimates specific values, e.g., energy efficiency) or to a building assurance.

Furthermore, the virtual model of the building may comprise essential data of the infrastructure. If the data of the other buildings in the vicinity are also known, new concepts regarding infrastructure sharing can be developed. If in one or several buildings essential infrastructure is turned out, their function can be taken over from the surrounding buildings (e.g., building A has a transformer failure without stream, nevertheless, one knows that building B owns an electric generator which can be used also for building A) Advantageously, by comparing the virtual models of the two or more buildings a simulation which calculates such effects is provided.

Beside the assessment of the building, its state and equipment, such a data model permits optionally-wise also an assessment of a rent party. The use of a building measured by sensors like IoT-sensors 180 can be also compared to other parties and real estates and it is possible to derive assessments, e.g., person A is very carefully to the infrastructure.

On the other hand, announcements in respect to defects of the assets or substance can be rewarded. If a defect of a damage is early known, it can be reacted often in a better way to it - and this is mostly more favourable. The virtual building model 110 can provide suitable interfaces, e.g., APPs for software and/or web service, or so-called indoor-viewers which generate a message by click on a defective object/area.

The quality of the building data can be also deposited in the model. This permits a credibility view, e.g., given data from a well-known enterprise or person can have a higher value and quality than crowd-sourced data. The data quality may optionally be also indicated in the model, e.g., by special colours For the protection of the data, in particularly from the building management system and/or IoT sensors 180, a public-public or non-public blockchain can be used in order to increase the credibility of the data. A blockchain is a growing list of records, blocks, which are linked using cryptographic methods. Blockchain data banks are assumed to be safe regarding manipulation, because the single blocks of information are encoded extensively and are stored decentralised. The probably well-known use of blockchain is the digital currency Bitcoin.

Blockchains which are readable by the public are widely used by cryptocurrencies. Private blockchains have been proposed for business use. Each block contains a cryptographic hash of the previous block for linking the two, a timestamp, and transaction data. The linked blocks form a chain. This iterative process confirms the integrity of the previous block, all the way back to the original genesis block. Therefore, by design, a blockchain is resistant to modification of the data. It is an open, distributed ledger that can record transactions between two parties efficiently and in a verifiable and permanent way. For use as a distributed ledger, a blockchain is typically managed by a peer-to-peer network collectively adhering to a protocol for inter-node communication and validating new blocks. Once recorded, the data in any given block cannot be altered retroactively without alteration of all subsequent blocks, which requires consensus of the network majority. Though blockchain records are not unalterable, blockchains may be considered secure by design.

The block time is the average time it takes for the network to generate one extra block in the blockchain. Some blockchains create a new block as frequently as every five seconds, others need more time. By the time of block completion, the included data becomes verifiable.

The blockchain itself contains the data bank in which all data of the real estate building are stored. For the validation process of this data generation ("mining") transactions are summarised into blocks. Every block refers to a valid block preceding to him, by which a chain, the "block chain", is generated. In contrast to customary data banks the blockchain is not stored on a single computer (server). All participants of the network ("full nodes") own an entire copy of the complete blockchain in their local memory. Therefore, such a data bank is called replicated, divided data bank. This feature enables all network participants to validate transactions locally, i.e. for themselves without having to count on an external supervision authority.

By storing data across its peer-to-peer network, the blockchain eliminates aa amount of risks that come with data being held centrally. The decentralized blockchain may use ad-hoc message passing and distributed networking. Peer-to-peer blockchain networks lack centralized points of vulnerability that computer crackers can exploit; likewise, it has no central point of failure. Blockchain security methods include the use of public-key cryptography. Data stored on the blockchain is generally considered incorruptible.

Currently, there are three types of blockchain networks - public blockchains, private blockchains and consortium blockchains. A public blockchain has absolutely no access restrictions. Anyone with an internet connection can send transactions to it as well as become a validator (i.e., participate in the execution of a consensus protocol). Usually, such networks offer economic incentives for those who secure them and utilize some type of a proof of stake or proof of work algorithm. Some of the largest, most known public blockchains are Bitcoin and Ethereum.

A private blockchain is permissioned. One cannot join it unless invited by the network administrators. Participant and validator access are restricted. This type of blockchains can be used for sensitive data of companies without sacrificing autonomy and running the risk of exposing sensitive data to the public internet.

A consortium blockchain is often said to be semi-decentralized. It, too, is permissioned but instead of a single organization controlling it, multiple companies might each operate a node on such a network. The administrators of a consortium chain restrict users' reading rights as they see fit and only allow a limited set of trusted nodes to execute a consensus protocol.

Every node in a decentralized system has a copy of the blockchain. Data quality is maintained by massive database replication and computational trust. No centralized "official" copy exists and no user is "trusted" more than any other.https://en.wikipedia.org/wiki/Blockchain - cite note-primer-4 Transactions are broadcast to the network using software. Messages are delivered on a best-effort basis. Mining nodes validate transactions, add them to the block they are building, and then broadcast the completed block to other nodes.

Blockchain permits furthermore so-called "smart contracts". Blockchain-based smart contracts are proposed contracts that could be partially or fully executed or enforced without human interaction. A computer system like the server 120 stores or receives data, determines with the help of a software code whether the conditions are fulfilled, so that contractually agreed actions are permitted or even are prescribed. In case of a permission, then the blockchain starts the suitable action. The present smart contract models based on customary digital technologies have the following features in common: they run on proprietary, centralised systems and need an intermediary authority. The blockchain does not need such intermediary authority as a mediator or any central knowledge authorities. The contract is deposited in the form of a program code and is observable on the blockchain. The contract contains the conditions which must be fulfilled, so that the also clearly defined duties can be initiated automatically.

Besides, turnover can be generated for an enterprise by the "smart contract" solutions implemented in the blockchain while the access to certain data (among other things from the building management system) and their actuality is provided with a "price tag". Thus, an updated date has another data value as a set of historical data. The data value can be linked with a price which is of interest for a facility manager or investor. Contributory parties improving the model qualitatively can be paid which increases the motivation to such a contribution.

The expenditure to evaluate the actual value of a real estate but also to carry out investments can be considerably shortened due to the improvement of the quality and reliability of the data. For example, the check of the heating system is stored digitally in the blockchain which is important for the property assurance, but also for the users, so that they can feel safe in the building.

Besides, the protection of the data and the "smart contract" implemented in the blockchain allows to charge for the value of the data. A real estate data platform for documents relating to safekeeping (test certificates, rent contracts, etc.) based on blockchain logic is thereby possible. With this approach enterprises can guarantee the integrity of their data and test and controlling processes can be automated.

According to the present invention, smart contracts on the blockchain basis which are automatically executed as soon as certain conditions can be also used in the field of real estate and building technology and allow new computer-aided solutions and offers. Data generated by the building management system and real estate management systems and transactions can be verified, validated and summarised to blocks based on blockchain technology.

The implemented contract (smart contract) pays the data supplier immediately after the query by the prospective customer (in crypto currency). Though apartments, rooms or whole building areas can rent themselves alone, without a broker is integrated. The blockchain sells the data, without any help from brokers. For a guarantee of legal requirements a possible solution would be an independent, administered and decentralised organised blockchain for real estate transactions.

Further questions shall be solved for a complete implementation of the virtual building mapping 110. At first, the acceptance of such a building modelling (BIM) should be improved. The additional expenditure (costs) by using such a model at the beginning of the planning of a building shall be compensated with the saved costs in the end. Especially, the generation, storage and correction of data shall be compensated. The control of the model needs to be clarified, especially regarding the exchange of new data for new customers/users. This implies a complete documentation about the changes in the model, including who, when, what, etc. A further aspect refers to the question if there is a single source of truth and if all actors work with the same data state. Perhaps it is necessary to install an incentive system to increase the data quantity as well as the data quality, also after the end of the construction phase for the optimisation of the operation of the building. This implies a dynamic update of the data model by changing information over time. Furthermore, product suppliers (e.g., windows, heating system ... etc.) deliver ideally the product data required for the BIM model as IFC (Industry Foundation Classes) data. In addition, a record must be provided for every product, which means a big expenditure for the compilation and maintenance phase.

All participants should work on this central virtual building model 110. The interface for the different software programmes shall be the IFC standard. If all participants can serve this interface and work on one single model and about the whole life cycle of the building, then one speaks of Big BIM. If only some participants or only for a certain time-period use the BIM model 110, one speaks of Little BIM.

The reality on the building sites on which BIM 110 is used reaches from subcontractors who pass their working report in the construction office on paper at the end of work where this is stored electronically (ideally without transfer mistakes), up to the subcontractors who record their activities and changes on electronic devices, and which become transferred/synchronised online. The same situation appears during the implementation phase. Facility manager must also balance their activities with the model 110, especially as so-called "crowd sourced" information does not run directly into the BIM model 110.

According to the present invention, a central virtual model 110 of a building or another facility is provided on a server 120 and multiple stakeholders (architects, suppliers, facility managers and/or users of the building or users of the building), as well as digital sensors as IoT sensors contribute to the digital model 120. In order the ensure the data quality and data security the present invention uses the blockchain technology for the BIM model. Blockchain is organized in that way that the application and the matching data not stored in a central authority (server) but are distributed over all participants of the system. All users of the technology take over together the function of a control authority which ensures the integrity and correctness of the system.

The fusion of the virtual building model 110 (BIM) and blockchain permits an optimised business process, with new functions and features for the current and new participants in the BIM model.

The advantages of such a fusion are the generation of incentives for activities as data acquisition and maintenance. The incentives can be represented by virtual credit as Bitcoin. The use of blockchain services and time can be also charged by virtual money. Furthermore, the data are stored decentralised, which is a main feature of blockchain and improves data security. Especially, the problem of documentation is solved as each transaction is documented automatically. By linking sensors, e.g. Internet-of Things sensors (IoT) 180 to the BIM model 110 described in a blockchain these sensors or groups of sensors become active participants and contributory actors of a data model BIM 110 (and on this way optionally revenue can be generated).

Furthermore, various products of different manufactures/suppliers can be introduced to the blockchain so that a spread of several software solutions can be harmonized. It is also possible to classify the activities and contributions of different stakeholders so that they have also different access rights.

In Fig. 2 the processing steps of the method according of the invention for mapping a virtual building model (10) especially for a real estate are illustrated. In step S100, blockchain-based transactions for data acquisition and mapping of the model (110) are used. In step S200, processing devices (130, 140, 150, 160, 170, 180, 190) are processing a data transaction message, wherein the data transaction message includes at least an identifier associated with a blockchain network and a data transaction amount. In step S300 the data transaction message is controlled and the data transaction amount by a control device (120) is stored.

Fig. 3 schematically illustrates a computer program product 300 comprising executable program code 350 configured to, when executed, perform the method according to the second aspect of the present invention.

In summary, the quite "monolithic" data model BIM 110 for a building is decentralised like a mosaic by a blockchain (private or public blockchain). By using the blockchain technology for a BIM data model 110 arises varied new business model possibilities which improve the BIM data (quality, quantity, consistency), and are only possible in such a decentralised system. Therefore, the key contribution of this invention is to facilitate data acquisition and data disclosure in the real estate area. Addressing building system data such as states, signals, communication on the building system level simplifies the definition of building tests that catch and prevent failures of building system modules or failures of the whole integrated building system. With this invention, continuous checking of building parameters gets easier, preventing the late detection of errors, which are always costly to detect and to repair.

## Claims

1. A system (100) for mapping a virtual building model (110) especially for a real estate, comprising:
the system is configured to use blockchain-based transactions for data acquisition and mapping of the model (110) ;
processing devices (130, 140, 150, 160, 170, 180, 190) configured to process a data transaction message, wherein the data transaction message includes at least an identifier associated with a blockchain network and a data transaction amount; and
a control device (120) configured to control the data transaction message and to store the data transaction amount.

2. The system (100) as claimed in claim 1, wherein the data transaction message is formatted based on one or more standards and includes a plurality of data elements, including at least a first data element configured to store the data transaction amount.

3. The system (100) as claimed in claim 1, wherein the processing devices are internet-of-things sensors (180) and/or smart phones (190) and/or servers (130, 170) and/or computing devices (140, 160).

4. The system as claimed in any one of claims 1 to 3, wherein an encrypted key is used for the transaction message and/or the transaction amount.

5. The system as claimed in any one of claims 1 to 4, wherein the data transaction message contains data of the building such as the construction plan, the equipment of the building, the history of the building, the users of the building and the infrastructure.

6. The system as claimed in any one of claims 1 to 5, wherein authorized stakeholders (210, 220) have access to the virtual building model.

7. The system as claimed in any one of claims 1 to 6, wherein the blockchain of the virtual building model (110) comprises smart contracts for authorized stakeholder.

8. A method for mapping a virtual building model (10) especially for a real estate, comprising:
using (S100) blockchain-based transactions for data acquisition and mapping of the model (110);
processing (S200) by processing devices (130, 140, 150, 160, 170, 180, 190) a data transaction message, wherein the data transaction message includes at least an identifier associated with a blockchain network and a data transaction amount; and
controlling (S300) the data transaction message and storing the data transaction amount by a control device (120) .

9. A method as claimed in claim 8, wherein the data transaction message is formatted based on one or more standards and includes a plurality of data elements, including at least a first data element configured to store the data transaction amount.

10. The method as claimed in claim 8 or 9, wherein an encrypted key is used for the transaction message and/or the transaction amount.

11. The method as claimed in any one of claims 8 to 10, wherein the transaction message contains data of the building such as the construction plan, the equipment of the building, the history of the building, the users of the building and the infrastructure.

12. The method as claimed in any one of claims 8 to 11, wherein authorized stakeholders (210, 220) have access to the virtual building model.

13. The method as claimed in any one of claims 8 to 12, wherein the blockchain of the virtual building model (110) comprises smart contracts for authorized stakeholders.

14. A cloud computing platform configured for use in the system as claimed in any one of claims 1 to 7.

15. A computer program product (300) comprising executable program code (350) configured to, when executed, perform the method according to any one of claims 8 to 13.
